# EUROPEAN PATENT SPECIFICATION

(11) **EP 4 135 055 B1**
(45) Date of publication and mention of the grant of the patent: **29.04.2026**
(21) Application number: 22461527.8
(22) Date of filing: 20.03.2022
(51) Int. Cl.: H10H 20/811, H10H 20/812, H10H 20/813, H10H 20/825

(54) **BIDIRECTIONAL LIGHT EMITTING DIODE**
BIDIREKTIONALE LEUCHTDIODE
DIODE ÉLECTROLUMINESCENTE BIDIRECTIONNELLE

(30) Priority: 14.08.2021 PL 43874421
(43) Date of publication of application: 15.02.2023
(73) Proprietor: Instytut Wysokich Cisnien Polskiej Akademii Nauk, 01-142 Warszawa (PL)
(72) Inventor: ZAK, Mikolaj, 66-110 Babimost (PL); MUZIOL, Grzegorz, 01-466 Warszawa (PL); SIEKACZ, Marcin, 03-395 Warszawa (PL); NOWAKOWSKI-SZKUDLAREK, Krzesimir, 01-710 Warszawa (PL); TURSKI, Henryk, 02-555 Warszawa (PL); SKIERBISZEWSKI, Czeslaw, 05-502 Kamionka (PL)
(74) Representative: AOMB Polska Sp. z.o.o.

(56) References cited:
- WO-A1-2020/206003
- JP-A- 2012 178 477
- US-A1- 2018 323 338
- US-B1- 6 365 911

## Description

The present invention relates to a bidirectional light emitting diode, which is built of nitrides of group III metals and has two current terminals, and in which the light emission ranging from 0.370 µm to 0.650 µm occurs when it is supplied with direct current, regardless of polarisation of such terminals, as well as to a method of fabrication of such diode.

Conventional light emitting diodes (LEDs) are built such that the diode's active region, which contains one or more quantum wells, is located between p- and n-type doped layers. Such a structure relates to all materials families used for fabricating diodes that emit light with the wavelength ranging from far ultraviolet (approx. 100 nm) to far infrared (approx. 1 mm). At present, commercially available light emitting diodes based on gallium nitride (GaN) and on alloys of gallium with indium (InGaN) and aluminium (AlGaN) emit light ranging from ultraviolet to green. The structure of such LEDs is disclosed e.g. in the book titled "Introduction to Nitride Semiconductor Blue Lasers and Light Emitting Diodes" by S. Nakamura and S. F. Chichibu [ISBN 9780748408368, CRC Press, 2000]. In such diodes light is emitted only when they are supplied with direct current, when a positive potential difference in relation to an *n*-type region is applied to a *p*-type region. This is so-called diode polarisation in the forward direction. When the polarisation of the supply current is opposite, the *p-n* junction in the LED is polarised in the reverse direction and does not cause light emission. When a conventional LED is supplied directly with alternating current, it can emit light only for one half-period, during which it is polarised in the forward direction. GaN-based LEDs are successfully used as efficient and energy-saving sources of household and industrial lighting. However, the current available in the power grid is alternating current, which gives rise to problems with direct power supply for LEDs. In order to supply them with power, external rectifier connections based on a Graetz bridge with additional voltage-regulator capacitors, which convert alternating current to direct current, can be used.

US6957899 B2 discloses a method of direct parallel connection of two series of LEDs to an alternating current source. In such a configuration, only one series of LEDs emits light for one half of the period, while the other series of LEDs emits light for the other half of the period. Disadvantages of such a solution are diode flicker with the frequency of the supply current and light emission by only half of the light emitting structures used in the connection.

US2004/0206970A1 and US7855388B2 disclose methods of connecting single light emitting diodes into larger modules so that they can operate with alternating current supply. For this purpose, bridge connections rectifying electric current that are integrated with LEDs (US6412971B1) or units that appropriately modulate the alternating current wave (US8598799B2) are used. Another solution that increases the efficiency of electric current conversion to light is to build a bridge rectifier from light emitting diodes, which is disclosed in "Alternating-current Light Emitting Diodes with a Diode Bridge Circuitry" [Jpn. J. Appl. Phys. 46, 1194 (2007)] and "Characteristics of Single-Chip GaN-Based Alternating Current Light-Emitting Diode" [Jpn. J. Appl. Phys. 47, 8808 (2008)].

Devices can be integrated also at the diode epitaxial structure level, as disclosed in US2011/0204376A1. In this case, a layer structure was created by the epitaxial method, wherein two LEDs were connected vertically by means of a *p*-type region. Such type of structures contained three current terminals: upper and lower ones for the *n*-type and a middle one for the *p*-type. After such diodes were connected appropriately in larger packets, light was emitted alternately by the upper and lower light emitting structures, depending on the current polarisation in individual half-periods of alternating current.

Light emitting devices characterised by the *n-p-n* epitaxial structure, built of nitrides of group III metals and containing tunnel junctions, which are disclosed in US9716209B2, are closest to the object of the invention. A *p-n* tunnel junction is located above an *n-p* light emitting diode. Thanks to the tunnel junction, both current terminals contact the *n*-type region. Tunnel junctions are commonly applied nowadays in GaN-based optoelectronic devices, but in all known cases they are connected with typical LEDs such that the structure emits light only with the tunnel junction polarisation in the reverse direction when the tunnel junction operates as in tunneling term. During an attempt at opposite polarisation of the whole structure, the LED region is polarised in the reverse direction and no carriers are supplied to the active region. Tunnel junctions in such devices play the role of interconnectors between several LEDs [Appl. Phys. Express 8, 082103 (2015)] or allow the substitution of the terminal type from a high-resistive contact to *p*-type for a low-resistive contact to *n*-type [Appl. Phys. Lett. 105, 141104 (2014)]. However, such an arrangement of tunnel junctions does not allow current flow and light emission with the polarisation of the epitaxial structure in both directions.

All the aforementioned publications disclose a connection of single LEDs characterised by a known structure (*n*-type region / active region / *p*-type region) in series or in parallel into larger groups in order to achieve light emission with alternating current supply. Regardless of the degree of integration of such known LEDs into larger modules, their principle of operation does not change because light is emitted by each LED only when it is polarised in the forward direction. Document JP2012178477A discloses a III-nitrides bi-directional light-emitting diode.

The purpose of the invention was to obtain a light emitting diode having two current terminals, which emits light with the wavelength ranging from 0.370 µm to 0.650 µm when it is supplied with direct current, regardless of the polarisation direction of such terminals.

This purpose is fulfilled by a diode according to the invention as defined in claim 1, which has an epitaxial layer structure built of nitrides of group III metals applied to a crystalline substrate, which structure contains a light emitting active region with at least one quantum well. The present invention consists in the aforementioned epitaxial layer structure containing at least one set of epitaxial layers composed of, counted from the crystalline substrate, a lower *n*-type conductivity layer, a lower tunnel junction, a lower *p*-type conductivity layer, an active region, an upper *p*-type conductivity layer, an upper tunnel junction and an upper *n*-type conductivity layer. Each successive set of such epitaxial layers is located on the upper *n*-type conductivity layer of the preceding set of epitaxial layers. The diode contains a first current terminal, connected electrically with the lower *n*-type conductivity layer closest to the substrate, and a second terminal, connected electrically with the upper *n*-type conductivity layer farthest from the substrate. In each of the aforementioned sets of epitaxial layers, the lower tunnel junction contains a first sublayer, which is *n*-type doped and adjacent to the lower *n*-type conductivity layer, and a second sublayer, which is *p*-type doped and adjacent to the lower *p*-type conductivity layer. The upper tunnel junction of each set of epitaxial layers contains a first sublayer, which is *p*-type doped and adjacent to the upper *p*-type conductivity layer, and a second sublayer, which is *n*-type doped and adjacent to the upper *n*-type conductivity layer.

According to the invention, each tunnel junction is made of an indium gallium nitride alloy In_{z}Ga_{1-z}N, wherein the indium content z ranges from 0 to 0.15. The doping level of each sublayer of the tunnel junction ranges from 1 x 10¹⁹ cm⁻³ to 5 x 10²⁰ cm⁻³, and the thickness of each tunnel junction ranges from 4 nm to 50 nm, with the thickness of each of its sublayers being at least 2 nm.

According to the invention, the active region is made of an indium gallium nitride alloy In_{y}Ga_{1-y}N and contains at least one quantum well with the width ranging from 1 nm to 25 nm, which is made of an indium gallium nitride alloy InₓGa₁₋ₓN. The indium content in both these alloys is determined by the correlation: 0 ≤ y < x ≤ 0.5, while the active region doping level is lower than 1 x 10¹⁸cm⁻³. In another variant of the diode according to the invention, each *n*-type conductivity layer is made of an indium gallium nitride alloy InᵤGa₁₋ᵤN, wherein the indium content u ranges from 0 to 0.15, while the *n*-type doping level of each layer ranges from 5 x 10¹⁷ cm⁻³ to 1 x 10²⁰ cm⁻³.

In another variant of the diode according to the invention, each *p*-type conductivity layer is made of an indium gallium nitride alloy InᵥGa₁₋ᵥN with the indium content v not higher than the indium content y in the indium gallium nitride alloy In_{y}Ga_{1-y}N, of which the active region is made. The *p*-type doping level of these layers ranges from 1 x 10¹⁸ cm⁻³ to 1 x 10²⁰ cm⁻³.

In yet another variant of the diode according to the invention, the doping level of each *p*-type conductivity layer decreases in the direction from the adjacent tunnel junction to the active region.

The bidireconal light emitting diode according to the invention is manufactured using a method which consists in fabricating an epitaxial layer structure on a crystalline substrate, with the structure's containing a light emitting active region with at least one quantum well, of nitrides of group III metals in the process of nitrogen plasma assisted molecular beam epitaxy (PAMBE) growth.

In a variant according to the invention, the epitaxial growth of the layer structure is performed in metal-rich conditions, and the epitaxial layers are applied at the temperature ranging from 600°C to 800°C. Nitrogen for epitaxial growth of the layer structure is supplied in the form of plasma excited by a power supply unit generating a power between 300 and 600 W, with the nitrogen flow between 1 and 5 millilitres per minute.

The present invention breaks the consensus prevailing among specialists that an active region, containing at least one quantum well, in a LED is located directly between n-type and p-type doped layers, and consequently light is generated only when the LED is polarised in the forward direction. Unexpectedly, it has turned out that the addition of two tunnel junctions to the set of epitaxial layers allows an effective supply of both types of carriers to the quantum wells and allows their radiative recombination, regardless of the direction of the supply current flow. Sets of epitaxial layers of the diode according to the invention can be connected vertically into stacks without increasing the quantity of current terminals, preserving said diode's light emission capability for both directions of the supply current flow. This allows an increase in the optical power of a single device in a simple manner, which is the sum of optical powers of the stacked sets of epitaxial layers.

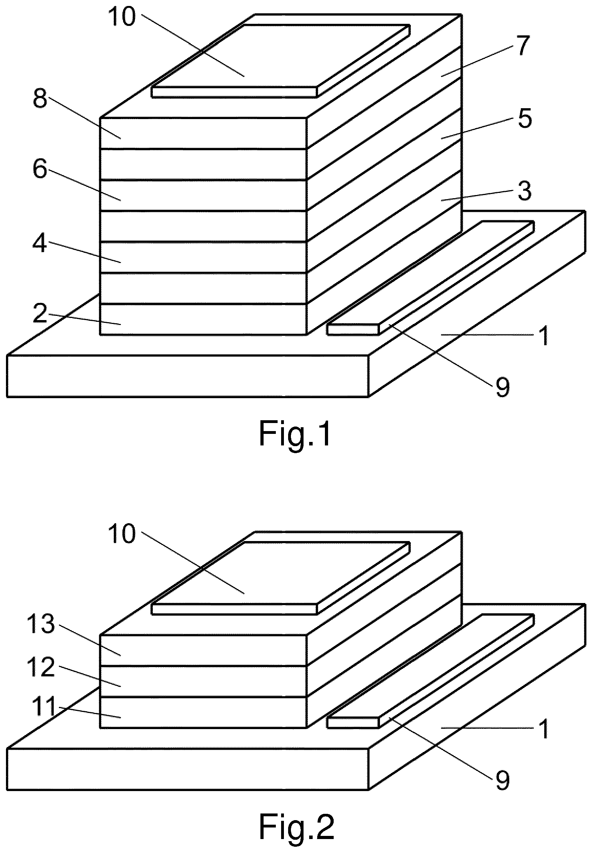

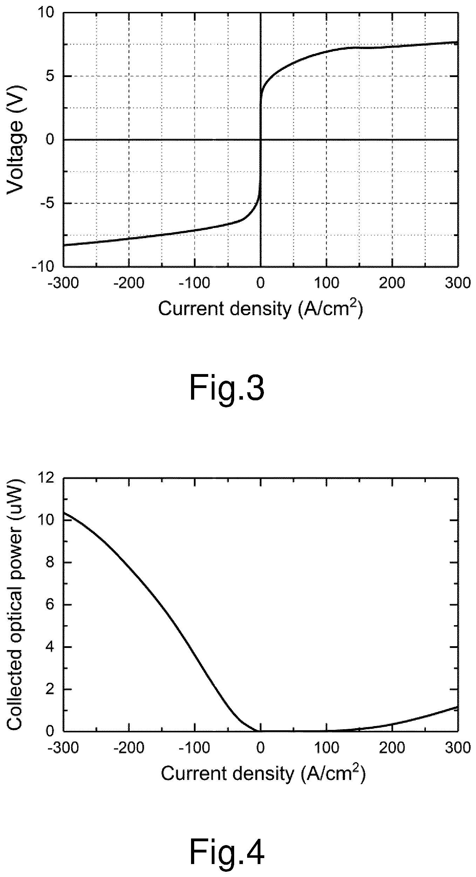

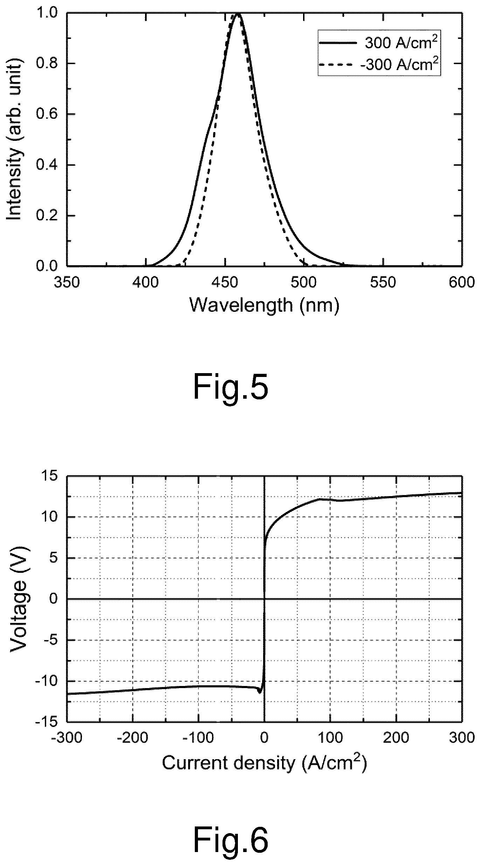

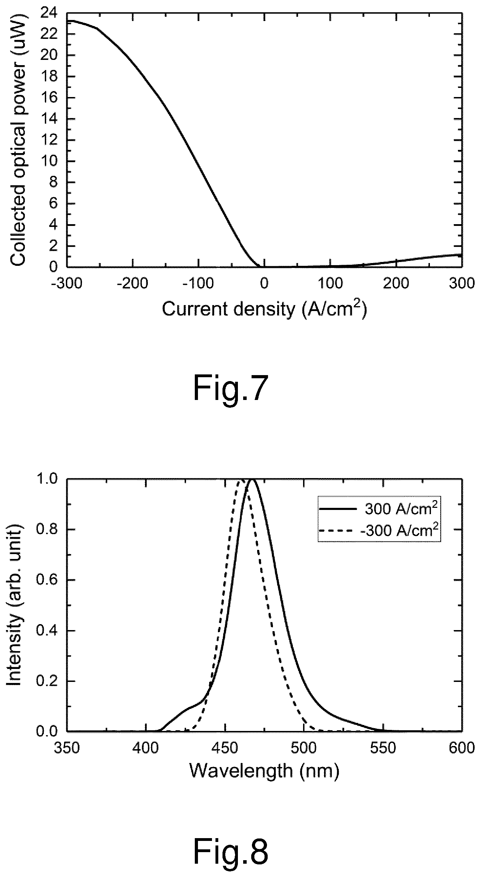

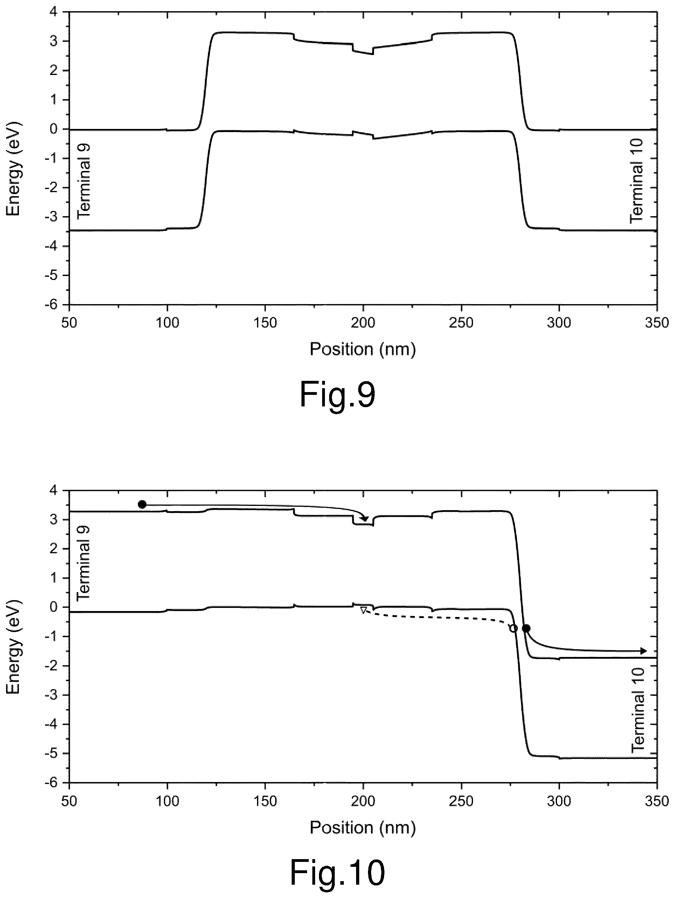

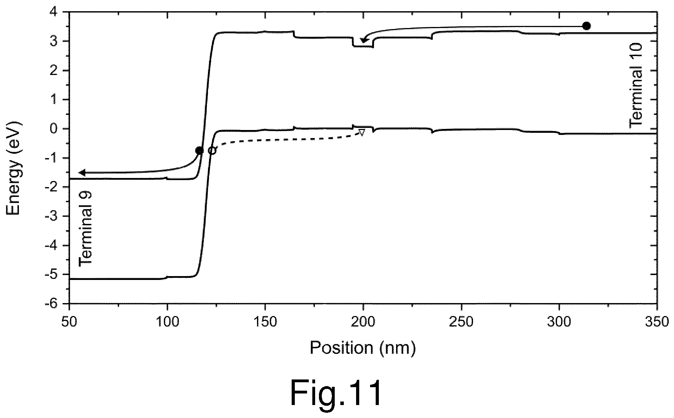

The invention is shown in the drawing, with Fig.1 presenting a schematic axonometric view of the diode according to the invention with one set of epitaxial layers, and Fig.2 presenting the same view of the diode according to the invention with three sets of epitaxial layers from Fig.1. Fig.3 presents a voltage-current characteristic of the first example diode according to the invention having one set of epitaxial layers, Fig.4 presents a light-current characteristic of the first diode, and Fig.5 presents electroluminescence spectra of the same diode with the current density of 300 A/cm² and -300 A/cm². Fig.6 presents a voltage-current characteristic of the second example diode according to the invention having two sets of epitaxial layers, Fig.7 presents a light-current characteristic of the second diode, and Fig.8 presents electroluminescence spectra of the same diode with the current density of 300 A/cm² and -300 A/cm². Figures from Fig.9 through Fig.11 present diagrams of band structures, which reflect the flow of carriers and the scheme of operation of the diode according to the invention in various voltage regimes, with Fig.9 relating to the zero potential difference between the current terminals, Fig. 10 relating to a positive potential of the second current terminal of the diode according to the invention in relation to its first current terminal, and Fig.11. relating to a negative potential of the second current terminal of such diode in relation to its first current terminal.

The invention is presented in more detail in the embodiment described below. An example diode according to the invention contains at least one set of epitaxial layers composed of, counted from the crystalline substrate 1, a lower *n*-type conductivity layer 2, a lower tunnel junction 3, a lower *p*-type conductivity layer 4, a light emitting active region 5, an upper *p*-type conductivity layer 6, an upper tunnel junction 7 and an upper *n*-type conductivity layer 8. Each successive set of epitaxial layers from 2 through 8 is located on the upper *n*-type conductivity layer 8 of the preceding set of epitaxial layers from 2 through 8. The diode according to the invention contains a first current terminal 9, connected electrically with the lower *n*-type conductivity layer 2 closest to the substrate 1, and a second current terminal 10, connected electrically with the upper *n*-type conductivity layer 8 farthest from the substrate 1. In each of the aforementioned sets of epitaxial layers from 2 through 8, the lower tunnel junction 3 contains a first sublayer, which is *n*-type doped and adjacent to the lower *n*-type conductivity layer 2, and a second sublayer, which is *p*-type doped and adjacent to the lower *p*-type conductivity layer 4. The upper, counted from the substrate 1, tunnel junction 7 contains a first sublayer, which is *p*-type doped and adjacent to the upper *p*-type conductivity layer 6, and a second sublayer, which is *n*-type doped and adjacent to the upper *n*-type conductivity layer 8. Fig.1 presents schematically the diode according to the invention containing only one set of layers from 2 through 8, while Fig.2 presents schematically the diode according to the invention containing three sets of layers from 2 through 8, whereby the lowest set 11 is located on the substrate 1, a middle set 12 is fabricated on the upper *n*-type conductivity layer 8, which set begins from the successive lower *n*-type conductivity layer 2, contains another light emitting active region 5 and ends with the upper *n*-type conductivity layer 8, on which a third successive lower *n*-type conductivity layer 2 is applied, which layer belongs to the third, highest, set 13 of layers from 2 through 8, among which another light emitting active region 5 is located. The embodiment described below presents a diode with one and with two sets of layers 2 through 8.

This diode was fabricated in the process of nitrogen plasma assisted molecular beam epitaxy (PAMBE) growth in a VG Semicon V90 reactor. The substrate 1 with the thickness of 350 µm, made of gallium nitride, was heated in a prechamber at the temperature of 150°C for 90 minutes. The heating of the substrate 1 was continued for 30 minutes in a preparatory chamber at the temperature of 650°C. The heated substrate 1 was transferred to a growth chamber. The layer epitaxy was performed in metal-rich conditions. Nitrogen in the form of plasma excited by radio frequencies by a power supply unit was used for the growth. Two independent sources of nitrogen plasma were used: in the first source the nitrogen flow was set at 1.6 cm³/min and the power of the power supply unit at 410 W, while in the second source these parameters were 1.3 cm³/min and 440 W, respectively. The remaining elements forming the alloys, such as gallium, indium and aluminium, and the dopant materials: magnesium (*p*-type dopant) and silicon (*n*-type dopant) with the purity above 99.999% were evaporated from standard Knudsen cells. At the temperature of 730 °C, initially the lower *n*-type region 2 with the thickness of 200 nm was fabricated of GaN doped with silicon in the quantity of 1 × 10¹⁹cm⁻³. Subsequently, the growth temperature was reduced to 650°C and the lower tunnel junction 3 was fabricated, composed of a first In_{0.02}Ga_{0.98}N sublayer with the thickness of 20 nm doped with silicon in the quantity of 1 × 10²⁰ cm⁻³ and of a second In_{0.02}Ga_{0.98}N sublayer with the thickness of 10 nm doped with magnesium in the quantity of 1 × 10²⁰ cm⁻³. The lower *p*-type region 4 was composed of an In_{0.02}Ga_{0.98}N layer with the thickness of 35 nm doped with magnesium such that the magnesium quantity in the layer decreased in a linear manner from 1 × 10²⁰ cm⁻³ to 2 × 10¹⁹ cm⁻³ along the initial 30 nm, and was equal to 2 × 10¹⁹cm⁻³ in the last 5 nm. The active region 5 was not doped and was composed of an In_{0.17}Ga_{0.83}N quantum well with the thickness of 10.4 nm surrounded from all sides by 30 nm thick layers of In_{0.08}Ga_{0.92}N. Above the active region 5, the upper *p*-type region 6 was composed of an In_{0.02}Ga_{0.98}N layer with the thickness of 35 nm doped with magnesium such that the magnesium quantity in the layer was equal to 2 × 10¹⁹ cm⁻³ along the initial 5 nm, and the concentration increased in a linear manner from 2 × 10¹⁹cm⁻³ to 1 × 10²⁰cm⁻³ along the successive 30 nm. The upper tunnel junction 7 was composed of two sublayers: a first (lower) In_{0.02}Ga_{0.98}N sublayer with the thickness of 10 nm doped with magnesium in the quantity of 1 × 10²⁰cm⁻³ and of a second (upper) In_{0.02}Ga_{0.98}N sublayer with the thickness of 20 nm doped with silicon in the quantity of 1 × 10²⁰cm⁻³. The upper *n*-type region 8 was composed of a GaN layer doped with silicon in the quantity of 3 × 10¹⁹cm⁻³, with the thickness of 100 nm, grown at the temperature of 730°C. In the case of fabricating a diode composed of two sets of epitaxial layers from 2 through 8, after applying the upper *n*-type layer 8 of the first set of epitaxial layers the layers from 2 through 8 of the upper set of epitaxial layers grew again.

The layer structures fabricated epitaxially were subjected to photolithography and reactive ion etching to form a mesa with the dimensions of 350 x 350 µm. The mesa was etched up to the depth of 500 nm in the case of one set of layers from 2 through 8, or up to the depth of 900 nm in the case of a stack of two sets of layers 2 through 8, that is, in both cases up to the level of the lower *n*-type layer 2 of the first set of epitaxial layers from 2 through 8. Metallisation composed of metals in the sequence being Ti/Al/Ni/Au with the thickness of 30/60/40/75 nm, composing the second current terminal 10, was applied to the top of the created mesas in the form of grates with the dimensions of 340 x 340 µm. Subsequently, metallisation of Ti/Al/Ni/Au with the thickness of 30/60/40/75 nm, composing the first current terminal 9, was applied on the side of the mesas on the top of the lower *n*-type layer 2 closest to the substrate.

The electrooptical properties were measured by the needle method, wherein a power supply unit and a voltage meter were connected with a spectrometer and an optical power meter. The optical power meter was placed at a constant height above the sample surface but it did not collect the whole light emitted from the sample to the outside, hence the presented optical power charts are purely qualitative. As reflected in Fig.3, a diode according to the invention conducts current flowing in the direction from the terminal 10 to the terminal 9 (positive polarisation, cf. Fig.10) and conducts current flowing in the direction from the terminal 9 to the terminal 10 (negative polarisation, cf. Fig.11). A stack of two sets of layers of a diode according to the invention behaves similarly, which is presented in Fig.6. A stack of two sets of epitaxial layers composing a diode according to the invention is characterised by a higher opening voltage of the whole structure due to two active regions in the structure. Light is emitted during current flow in both directions, which is shown in Fig.4 for one set of epitaxial layers and in Fig.7 for two sets of epitaxial layers, with the emitted power being approx. 10-20 times higher for negative polarisation than for positive polarisation in both cases. This effect is explained by the presence of strong piezoelectric fields in the active region 5 of the structure, where in the case of power supply with a negative polarisation current the barrier to the escape of the electrons from the well is bigger than in the positive direction. When comparing Fig.7 to Fig.4, it can be noticed that a diode according to the invention, composed of two sets of layers from 2 through 8, with one set located above the other, makes it possible to double the emitted optical power, which is particularly visible in the case of a negative polarisation current flow. Fig.5 and Fig.8 present spectra of emissions from such structures of diodes according to the invention, measured at the current density of 300 A/cm² and -300 A/cm². For both embodiments, the wavelength of the emitted light is approx. 460 nm.

In the described diode, during the current flow both from the terminal 9 to the terminal 10 and from the terminal 10 to the terminal 9 light coming from the quantum wells of the active region 5 is emitted. In the conditions of equilibrium, without potential difference applied between terminals 9 and 10, current does not flow and no light is emitted from the active region 5, which is presented in Fig.9. Where a positive potential difference in relation to the terminal 9 is applied to the terminal 10 (Fig.10), the lower tunnel junction 3 operates in the forward direction and the electrons, due to their high mobility, flow through the lower *p*-type doped region 4 and reach the active region 5. The upper tunnel junction 7, in turn, is polarised in the reverse direction and operates in tunneling term. The electrons in the area of the tunnel junction 7 are tunnelling from the valence band of its *p*-type sublayer to the conduction band of the *n*-type sublayer. Next, through the upper *n*-type layer 8 the electrons reach the terminal 10 or the lower *n*-type layer 2 of the successive set of epitaxial layers from 2 through 8, depending on the quantity of single sets of these layers. At the same time, holes are generated in the valence band of the p-type sublayer of the tunnel junction 7 and flow through the upper *p*-type region 6 to the active region 5. The electrons and the holes, supplied from the side of the terminal 9 and of the terminal 10, respectively, undergo radiative recombination in the quantum well of the active region 5. In the case of an opposite polarisation of the structure of a diode according to the invention, that is, where the potential of the terminal 10 is negative in relation to the terminal 9 (Fig.11), the flow of carriers to the active region 5 is analogous, with the difference being that electrons then are supplied from the side of the terminal 10 and the holes then are supplied from the side of the terminal 9, while the lower tunnel junction 3 operates in the reverse direction in tunneling term while the upper tunnel junction 7 operates in the forward direction.

## Claims

1. A bidirectional light emitting diode having two current terminals, which emits light with a wavelength ranging from 0.370 µm to 0.650 µm when it is supplied with a direct current, regardless of the polarisation direction of the terminals, having an epitaxial layer structure built of nitrides of group III metals applied to a crystalline substrate, wherein the aforementioned layer structure contains at least one set (2-8) of epitaxial layers composed of, counted from the crystalline substrate (1), a lower n-type conductivity layer (2), a lower tunnel junction (3), a lower p-type conductivity layer (4), an active region (5), an upper p-type conductivity layer (6), an upper tunnel junction (7) and an upper n-type conductivity layer (8), whereby each successive set of epitaxial layers (2-8) is located on the upper n-type conductivity layer (8) of the preceding set of epitaxial layers (2-8), wherein the diode contains a first current terminal (9), connected electrically with the lower n-type conductivity layer (2) closest to the substrate (1), and a second current terminal (10), connected electrically with the upper n-type conductivity layer (8) farthest from the substrate (1), while in each of the aforementioned sets (2-8) of epitaxial layers, the lower tunnel junction (3) contains a first sublayer, which is n-type doped and adjacent to the lower n-type conductivity layer (2), and a second sublayer, which is p-type doped and adjacent to the lower p-type conductivity layer (4), and the upper tunnel junction (7) contains a first sublayer, which is p-type doped and adjacent to the upper p-type conductivity layer (6), and a second sublayer, which is n-type doped and adjacent to the upper n-type conductivity layer (8), wherein each tunnel junction (3, 7) is made of an indium gallium nitride alloy In_{z}Ga_{1-z}N, wherein the indium content z is larger than 0 and less than 0.15 and is the same in each of its sublayers, the doping level of each of its sublayers ranges from 1 x 1 0 ¹⁹ cm ⁻³ to 5 x 1 0²⁰ cm ⁻³ , and the thickness of each tunnel junction ranges from 4 nm to 50 nm, with the thickness of each of its sublayers being at least 2 nm, while the active region (5) is made of an indium gallium nitride alloy In_{y}Ga_{1-y}N and contains one quantum well with the width ranging from 1 nm to 25 nm, which is made of an indium gallium nitride alloy InₓGa₁₋ₓN, whereby the indium content in all these indium gallium nitride alloys is determined by the relation *0 ≤ y < x ≤* 0.5and active region doping level is lower than 1 × 10¹⁸ cm⁻³;
wherein said bidirectional light emitting diode is manufactured using a method which consists of fabricating an epitaxial layer structure of nitrides of group III metals on a crystalline substrate, wherein the epitaxial layer structure is fabricated in the process of nitrogen plasma assisted molecular beam epitaxy (PAMBE) growth.

2. The diode according to claim 1, wherein each n-type conductivity layer (2, 8) is made of an indium gallium nitride alloy InᵤGa₁₋ᵤN, wherein the indium content u ranges from 0 to indium content 0.15, while the n-type doping level of each layer (2, 8) ranges from 5 x 1 0 ¹⁷ cm ⁻³ to 1 x 1 0²⁰cm ⁻³.

3. The diode according to claim 1 or 2, wherein each p-type conductivity layer (4, 6) is made of an indium gallium nitride alloy InvGa₁₋ᵥN, wherein the indium content v ranges from indium content z in the indium gallium nitride alloys of all the sublayers of the tunnel junction (3, 7) to the indium content y in the indium gallium nitride alloy of the active region (5), while the p-type doping level of each of these layers (4, 6) ranges from 1 x 1 0 ¹⁸ cm ⁻³ to 1 x 1 0²⁰ cm ³.

4. The diode according to claim 3, wherein the doping level of each p-type conductivity layer (4, 6) decreases in the direction from the adjacent tunnel junction (3, 7) to the active region (5).

5. The diode according to any of the preceding claims, wherein the epitaxial growth of the layer structure is performed in metal-rich conditions, and the epitaxial layers (2-8) are applied at the temperature ranging from 600 ⁰ C to 800⁰ C, while nitrogen for epitaxial growth of the layer structure is supplied in the form of plasma excited by a power supply unit generating a power between 300 and 600 W, with the nitrogen flow between 1 and 5 milliliters per minute.

## Patentansprüche

1. Eine bidirektionale Leuchtdiode mit zwei Stromanschlüssen, die bei Gleichstromversorgung unabhängig von der Polarisationsrichtung der Anschlüsse Licht mit einer Wellenlänge im Bereich von 0,370 µm bis 0,650 µm emittiert, mit einer Epitaxieschichtstruktur aus Nitriden von Metallen der Gruppe III, die auf ein kristallines Substrat aufgebracht ist, wobei die vorgenannte Schichtstruktur mindestens einen Satz (2 - 8) von Epitaxieschichten umfasst, die, vom kristallinen Substrat (1) aus gezählt, aus einer unteren n-Leitfähigkeitsschicht (2), einem unteren Tunnelübergang (3), einer unteren p-Leitfähigkeitsschicht (4), einem aktiven Bereich (5), einer oberen p-Leitfähigkeitsschicht (6), einem oberen Tunnelübergang (7) und einer oberen n-Leitfähigkeitsschicht (8) besteht, wobei sich jeder aufeinanderfolgende Satz von Epitaxieschichten (2 - 8) auf der oberen n-Leitfähigkeitsschicht (8) des vorhergehenden Satzes von Epitaxieschichten (2 - 8) befindet, wobei die Diode einen ersten Stromanschluss (9), der elektrisch mit der unteren n-Leitfähigkeitsschicht (2) verbunden ist, die dem Substrat (1) am nächsten liegt, und einen zweiten Stromanschluss (10), der elektrisch mit der oberen n-Leitfähigkeitsschicht (8) verbunden ist, die am weitesten vom Substrat (1) entfernt ist, aufweist, wobei in jedem der vorgenannten Sätze (2 -8) von Epitaxieschichten der untere Tunnelübergang (3) eine erste Unterschicht enthält, die n-dotiert ist und an die untere n-Leitfähigkeitsschicht (2) angrenzt, und eine zweite Unterschicht, die p-dotiert ist und an die untere p-Leitfähigkeitsschicht (4) angrenzt, und der obere Tunnelübergang (7) eine erste Unterschicht, die p-dotiert ist und an die obere p-Leitfähigkeitsschicht (6) angrenzt, und eine zweite Unterschicht, die n-dotiert ist und an die obere n-Leitfähigkeitsschicht (8) angrenzt, enthält, **dadurch gekennzeichnet, dass** jeder Tunnelübergang (3, 7) aus einer Indiumgalliumnitridlegierung InₓGa₁₋ₓN besteht, wobei der Indiumgehalt x größer als 0 und kleiner als 0,15 ist und in jeder seiner Unterschichten gleich ist, der Dotierungsgrad jeder seiner Unterschichten im Bereich von
1 x 10 ¹⁹ cm ⁻³ bis 5 x 1 0²⁰ cm ⁻³, und die Dicke jedes Tunnelübergangs im Bereich von 4 nm bis 50 nm liegt, wobei die Dicke jeder seiner Unterschichten mindestens 2 nm beträgt, wobei der aktive Bereich (5) aus einer Indiumgalliumnitridlegierung In_{y}Ga_{1-y}N besteht und einen Quantentopf mit einer Breite im Bereich von 1 nm bis 25 nm enthält, der aus einer Indiumgalliumnitridlegierung InₓGa₁₋ₓN besteht, wobei der Indiumgehalt in allen diesen Indiumgalliumnitridlegierungen durch die Beziehungen
*0 ≤ y < x ≤ 0,5* bestimmt wird und der Dotierungsgrad des aktiven Bereichs niedriger als 1 x 10¹⁸ cm⁻³ ist; wobei die bidirektionale Leuchtdiode unter Verwendung eines Verfahrens hergestellt wird, das darin besteht, eine Epitaxieschichtstruktur aus Nitriden von Metallen der Gruppe III auf einem kristallinen Substrat herzustellen, wobei die Epitaxieschichtstruktur im Prozess des Stickstoffplasma-unterstützten Molekularstrahlepitaxie (PAMBE)-Wachstums hergestellt wird.

2. Diode nach Anspruch 1, **dadurch gekennzeichnet, dass** jede n-Typ-Leitfähigkeitsschicht (2, 8) aus einer Indiumgalliumnitridlegierung_-_{InxGa1-xN} hergestellt ist, wobei der Indiumgehalt x von 0 bis zu einem Indiumgehalt von 0,15 in den Indiumgalliumnitridlegierungen aller Unterschichten des Tunnelübergangs (3, 7) reicht, während der n-Typ-Dotierungsgrad jeder Schicht (2, 8) von 5 x 10 ¹⁷ cm ⁻³ bis 1 x¹⁰²⁰ cm ⁻³reicht.

3. Diode nach Anspruch 1 oder 2, **dadurch gekennzeichnet, dass** jede p-Typ-Leitfähigkeitsschicht (4, 6) aus einer Indiumgalliumnitridlegierung InₓGa₁₋ₓN hergestellt ist, wobei der Indiumgehalt x von x in den Indiumgalliumnitridlegierungen aller Unterschichten des Tunnelübergangs (3, 7) bis zu einem Indiumgehalt x in der Indium-Gallium-Nitrid-Legierung des aktiven Bereichs (5) reicht, während der p-Typ-Dotierungsgrad jeder dieser Schichten (4, 6) von 1 x 1 0 ¹⁸ cm ⁻³ bis 1 x 1 0²⁰ cm ³reicht.

4. Diode nach Anspruch 3, **dadurch gekennzeichnet, dass** der Dotierungsgrad jeder p-Typ-Leitfähigkeitsschicht (4, 6) in der Richtung vom benachbarten Tunnelübergang (3, 7) zum aktiven Bereich (5) abnimmt.

5. Diode nach einem der vorhergehenden Ansprüche, **dadurch gekennzeichnet, dass** das epitaktische Wachstum der Schichtstruktur unter metallreichen Bedingungen erfolgt und die Epitaxieschichten (2 - 8) bei einer Temperatur im Bereich von 600 ^{0 C} bis 800 ^{0 C} aufgebracht werden, während Stickstoff für das epitaktische Wachstum der Schichtstruktur in Form von Plasma zugeführt wird, das durch eine Stromversorgungseinheit mit einer Leistung zwischen 300 und 600 W angeregt wird, wobei der Stickstoffstrom zwischen 1 und 5 Milliliter pro Minute beträgt.

## Revendications

1. Une diode électroluminescente bidirectionnelle ayant deux bornes de courant, qui émet de la lumière avec une longueur d'onde allant de 0,370 µm à 0,650 µm lorsqu'elle est alimentée par un courant continu, quel que soit le sens de polarisation des bornes, ayant une structure de couche épitaxiale constituée de nitrures de métaux du groupe III appliquée à un substrat cristallin, dans laquelle la structure de couche susmentionnée contient au moins un ensemble (2 - 8) de couches épitaxiales composées, à partir du substrat cristallin (1), d'une couche conductrice de type n inférieure (2), d'une jonction tunnel inférieure (3), d'une couche conductrice de type p inférieure (4), d'une région active (5), d'une couche conductrice de type p supérieure (6), d'une jonction tunnel supérieure (7) et d'une couche conductrice de type n supérieure (8), chaque ensemble successif de couches épitaxiales (2 - 8) étant situé sur la couche conductrice de type n supérieure (8) de l'ensemble précédent de couches épitaxiales (2-8), la diode contenant une première borne de courant (9), connectée électriquement à la couche conductrice de type n inférieure (2) la plus proche du substrat (1), et une deuxième borne de courant (10), connectée électriquement à la couche conductrice de type n supérieure (8) la plus éloignée du substrat (1), tandis que dans chacun des ensembles (2 - 8) susmentionnés de couches épitaxiées, la jonction tunnel inférieure (3) contient une première sous-couche dopée de type n et adjacente à la couche conductrice de type n inférieure (2), et une deuxième sous-couche dopée de type p et adjacente à la couche conductrice de type p inférieure (4), et la jonction tunnel supérieure (7) contient une première sous-couche, dopée de type p et adjacente à la couche conductrice de type p supérieure (6), et une deuxième sous-couche, dopée de type n et adjacente à la couche conductrice de type n supérieure (8), **caractérisée en ce que** chaque jonction tunnel (3, 7) est constituée d'un alliage de nitrure de gallium et d'indium InₓGa₁₋ₓN, dans laquelle la teneur en indium x est supérieure à 0 et inférieure à 0,15 et est identique dans chacune de ses sous-couches, le niveau de dopage de chacune de ses sous-couches est compris entre
1 x 10¹⁹ cm⁻³ à 5 x 10²⁰ cm⁻³ , et l'épaisseur de chaque jonction tunnel est comprise entre 4 nm et 50 nm, l'épaisseur de chacune de ses sous-couches étant d'au moins 2 nm, tandis que la région active (5) est constituée d'un alliage de nitrure de gallium et d'indium In_{y}Ga_{1-y}N et contient un puits quantique d'une largeur comprise entre 1 nm et 25 nm, qui est constitué d'un alliage de nitrure de gallium et d'indium InₓGa₁₋ₓN, la teneur en indium de tous ces alliages de nitrure de gallium et d'indium étant déterminée par la relation
*0 ≤ y < x ≤ 0,5 et le* niveau de dopage de la région active est inférieur à 1 x 10¹⁸ cm⁻³; dans laquelle ladite diode électroluminescente bidirectionnelle est fabriquée à l'aide d'une méthode qui consiste à fabriquer une structure de couche épitaxiale de nitrures de métaux du groupe III sur un substrat cristallin, dans laquelle la structure de couche épitaxiale est fabriquée dans le processus de croissance par épitaxie par faisceaux moléculaires assistée par plasma d'azote (PAMBE).

2. La diode selon la revendication 1, **caractérisée en ce que** chaque couche conductrice de type n (2, 8) est constituée d'un alliage de nitrure de gallium et d'indium InₓGa₁₋ₓN, dans lequel la teneur en indium x est comprise entre 0 et 0,15 dans les alliages de nitrure de gallium et d'indium de toutes les sous-couches de la jonction tunnel (3, 7), tandis que le niveau de dopage de type n de chaque couche (2, 8) est compris entre 5 x 10¹⁷ cm⁻³ et 1 x 10²⁰ cm⁻³.

3. La diode selon la revendication 1 ou 2, **caractérisée en ce que** chaque couche conductrice de type p (4, 6) est constituée d'un alliage de nitrure de gallium et d'indium InₓGa₁₋ₓN, dans lequel la teneur en indium x est comprise entre la teneur en indium x dans les alliages de nitrure de gallium et d'indium de toutes les sous-couches de la jonction tunnel (3, 7) à la teneur en indium x dans l'alliage de nitrure de gallium et d'indium de la région active (5), tandis que le niveau de dopage de type p de chacune de ces couches (4, 6) est compris entre 1 x 10¹⁸ cm⁻³ et 1 x 10²⁰ cm³.

4. La diode selon la revendication 3, **caractérisée en ce que** le niveau de dopage de chaque couche conductrice de type p (4, 6) diminue dans la direction de la jonction tunnel adjacente (3, 7) vers la région active (5).

5. La diode selon l'une quelconque des revendications précédentes, **caractérisée en ce que** la croissance épitaxiale de la structure de couche est réalisée dans des conditions riches en métaux, et que les couches épitaxiales (2-8) sont appliquées à une température comprise entre 600 °C et 800 °C , tandis que l'azote pour la croissance épitaxiale de la structure de couche est fourni sous forme de plasma excité par un bloc d'alimentation générant une puissance comprise entre 300 et 600 W, avec un débit d'azote compris entre 1 et 5 millilitres par minute.
